Europäisches Patentamt

**European Patent Office**

**Office européen des brevets**

(11) Publication number: **0 135 294**
**A2**

(12) **EUROPEAN PATENT APPLICATION**

(21) Application number: **84304910.7**

(22) Date of filing: **18.07.84**

(51) Int. Cl.⁴: **H 01 L 31/06**
**H 01 L 31/18**

(30) Priority: **18.07.83 US 514688**

(43) Date of publication of application:
**27.03.85 Bulletin 85/13**

(84) Designated Contracting States:
**BE CH FR GB IT LI NL**

(71) Applicant: **ENERGY CONVERSION DEVICES, INC.**
**1675 West Maple Road**
**Troy Michigan 48084(US)**

(72) Inventor: **Ovshinsky, Stanford R.**
**2700 Squirrel Road**
**Bloomfield Hills Michigan 48013(US)**

(74) Representative: **Boon, Graham Anthony et al,**
**Elkington and Fife High Holborn House 52/54 High**
**Holborn**
**London, WC1V 6SH(GB)**

(54) Enhanced narrow band gap alloys for photovoltaic applications.

(57) An optimized narrow band gap alloy which is especially useful in tandem photovoltaic devices is formed from germanium, tin and/or lead and at least one density of states reducing element. The depositing species are activated in a UHV, contaminant-free environment and deposited to form a contaminant-free, substantially tetrahedrally co-ordinated alloy material with hydrid orbitals. Fluorine is preferably added to the alloy material to (1) reduce the density of states through compensation, and (2) promote and expand elements with which it bonds into tetrahedral co-ordination whereby heretofore unavailable orbitals may be utilized.

FIG I

EP 0 135 294 A2

-1-

## ENCHANCED NARROW BAND GAP ALLOYS FOR PHOTOVOLTAIC APPLICATIONS

## BACKGROUND OF THE INVENTION

This invention relates generally to narrow band gap materials and more particularly to materials having (1) narrow band gaps as low as 1.1 eV or below and (2) a low density of defect states (as used herein,"density of defect states" is defined as the number of defect states per unit volume in the band gap of a given material). By employing narrow band gap materials, it is possible to produce efficient tandem (multi-celled) photovoltaic devices which fully utilize the spectrum of available sunlight. Such tandem devices employing a narrow band gap cell would possess the capability of raising solar cell efficiencies from the present 10% range to the 30% range, thereby resulting in worldwide use of amorphous photovoltaic energy. Accordingly, the instant invention has its most important application in making ultra-efficient photoresponsive alloys such as photovoltaic solar cells of p-i-n and tandem p-i-n type constructions.

Prior to the instant invention, fluorine and hydrogen were used to compensate for the dangling bonds of amorphous silicon, thereby producing photovoltaic quality alloys and devices. However, it has proven difficult , using conventional approaches, to have hydrogen and fluorine to satisfactorily provide a compensating function when employed in combination with germanium, germanium and a dopant, tin, tin and a dopant, lead, lead and a dopant or combinations thereof, (hereinafter also referred to as "primary materials") for producing a narrow band gap material. (By compensation is meant not only the elimination of the dangling bonds, but also the development of a new chemical configuration in which no dangling bonds are present). Applicant has identified the failure of fluorine and hydrogen to compensate for the dangling bonds

-2-

of narrow band gap materials as being directly associated with the tendency of germanium, tin and lead to become divalent or assume other non-tetrahederal configurations. This invention solves this problem by causing these primary materials to bond in a proper configuration for forming low band gap materials. More particulary, the instant invention minimizes or eliminates the tendency of such narrow band gap materials to assume divalent, distorted tetrahedral, or other non-tetrahedral co-ordination. While the tendency is present in germanium alloys, it is even more pronounced in forming tin and lead alloys. More specifically the tendency of the alloy materials to assume non-tetrahedral co-ordination is due to the presence of a so called "inert pair" of valence electrons which is formed when two of the four valence electrons exhibit decreased reactivity. This decrease in reactivity has previously been considered insolvable, since the inert pair appears as a spinless defect rather than as a dangling bond, thereby confusing and mystifying the scientific community.

The present invention solves the problem by promoting or activating the inert pair so as to expand the co-ordination thereof, whereby the inert pair assumes a proper configuration which permits their use in bonding with the compensating element or elements. The present invention provides a procedure through which the co-ordination of the lone or inert pair of valence electrons can be expanded. This results, for the first time, in the production of low band gap materials which have the prerequisite low density of defect states (less than $10^{16}$ cm$^{-3}$(eV$^{-1}$) in the energy gaps thereof.

-3-

The procedure includes the steps set forth below:

1.  Elimination of those competing reactions which have the capability of (1) interferring with or prohibiting the activation of the inert pair of valence electrons, and (2) inactivating the remaining two available bonding sites so proper electronic and atomic configurations cannot be formed. In the preferred embodiment, competing reactions may be eliminated in the first instance by providing an ultrahigh vacuum (UJV) deposition chamber (at least $10^{-7}$ to $10^{-9}$ torr). It is thereby possible to insure that chemical and electronic excitation processes have the opportunity to occur without interference. In these chemical and electronic excitation processes (1) the lone pair of valence electrons is activated, and (2) undesirable contaminants are substantially eliminated from the deposition environment and therefore cannot compete for available bonding sites.

2.  Providing density of states reducing element(s) such as hydrogen and fluorine, in a form which will compensate the low band gap alloy materials. Each reducing element will be discussed individually below.

    a. HYDROGEN: Atomic hydrogen is required. While molecular hydrogen does not expand the coordination of germanium, tin or lead, in its activated form, hydrogen has

-4-

more opportunities to bond with the dangling bonds of the tetrahedral or divalent orbitals of such low band gap materials. Atomic hydrogen is enhanced by a proper deposition environment. For example, in an UHV environment, (1) atomic hydrogen is easier to create, and (2) impurities are substantially eliminated. In this manner impurities are prevented from either (1) competing with the density of states reducing element(s) for the available bonding sites, or (2) quenching free radical lifetimes, or (3) breaking the bonds which the hydrogen atoms form.

b. FLUORINE: Fluorine is provided in free radical form (by various excitation processes) which enhance the alloy formation with or without hydrogen. Fluorine, in free radical form , moreover, can increase the co-ordination number, i.e., to promote or activate the inert pair of valence electrons, which pair is responsible for nontetrahedral configurations of the alloy which can form defect state. It is possible the inert pair has some bonding configurations and interactive relationships similar to lone pairs in other elements. Fluorine: which is called the super halogen because it has extremely high electronegativity, and in fact is the most electronegative element, accomplishes the task of promoting and activating the inert pair of valence electrons by expanding the orbitals. It further (1) eliminates dangling bonds, (2) provides ionicity to the bonding to help relieve stresses in the alloyed materials, and (3) acts as a bridging or crosslinking structural element in the

-5-

expanded structural configurations. Fluorine, therefore, chemically activates the inert pair of valence electrons and promotes that pair to a proper bonding configuration.

c.CHLORINE: Although ineffective as a tetrahedral co-ordination promoter when used with silicon, chlorine can be used as a tetrahedral co-ordination promoter with elements, such as germanium, having larger atoms which are more compatible with the large (relative to fluorine) atoms of chlorine.

3.Providing external excitation to promote the proper tetrahedral bonding. It may also be desirable to externally excite (preferably direct external excitation) the primary material(s) so that the energy of the inert pairs of valence electrons thereof are raised.

thereby increasing their reactivity. Alternatively or concomitantly, the energy of the substrate and the alloy being deposited thereon can be raised to the activation level necessary for promoting the orbitals and exciting the electrons to ultimately increase the reactivity of the inert pair of valence electons. The excitation, however accomplished, aids in generating the chemical reactions necessary between the primary materials,such as germanium, and the compensating and orbital-expanding elements, such as fluorine. As should now be apparent, the energy needed to promote the orbitals of the inert pair of valence electrons may be provided by (1) an orbital expanding chemical element, (2)

-6-

excitation of the primary material, or (3) energizing the substrate during the deposition process. These possible energy providing methods, whether applied singly or in combination, contribute to activate the valence electron orbitals so the proper bonding configurations, which exhibit a low density of defect states, occur.

Therefore, the instant invention provides (1) means for chemical and excitational expansion of low energy orbitals which is necessary to produce narrow band gap materials having a low density of states, thereby promoting the proper utilization of free fluorine atoms which may then serve expansion purpose and help, through etching activity, which also aids in providing "clean orbitals" for forming tetrahedral bonding configurations; (as used herein the term "clean orbitals" refers to those orbitals in which no competing bonding reactions have occurred): and (2) an ultra high vacuum environment to insure that these bonding reactions occur without interfering reactions, thereby aiding in the formation of tetrahedral co-ordination. In one embodiment, the clean orbitals are provided by the UHV by eliminating competing impurities such as undesired oxygen, water vapor, carbon, etc. The strong chemical bonding of fluorine and particularly hydrogen to the primary material(s) is also enchanced by (1) excitation of the electrons of the primary material, such as germanium, which can be accomplished by means such as ultraviolet light; (2) excitation of the deposited surface, such as by ultraviolet light to provide surface energy and mobility, and (3) creation of free atoms for and in the density of states reducing element(s) which can be accomplished by the use of ultraviolet light, microwave and radio frequencies, heat, catalytic materials such as platinum or palladium wires, etc. Additonally, the activated surface provides for (1) the formation of free atoms, and (2) the generation of the mobility necessary for attaining tetrahedral co-ordination. The foregoing excitation techniques are to be performed in an environment, preferably a UHV environment, which permits reactions to take place in sufficient number and within a controlled period of time to create new chemical configurations and eliminate dangling bonds, defects and spinless defects to which such alloyed materials would otherwise fall prey. Note that while an UHV environment represents a preferred embodiment, the present invention is not so limited. Moreover, any environment which enhances the proclivity toward tetrahedral co-ordination may be employed. For example, a microwave glow discharge deposition technique, characterized by a rapid rate of deposition and utilizing pure reaction materials, may also provide an environment conducive to the formation of tetrahedral co-ordination.

The present invention results in narrow band gap, amorphous materials having (1) a low density of defect states (below $10^{15}-cm^{-3}$) and (2) a much higher degree of local order, resulting in improved doping efficiencies.

In order to produce the improved narrow band gap alloy described herein, a seemingly insoluable problem has been solved without resorting to conventional plasma deposition processes previously utilized to produce good quality amorphous silicon materials. The process of the present invention can also be used to form amorphous silicon alloys, although silicon does not tend to form divalent compunds, vis-a-vis, germanium, tin and lead.
However, where silicon does have defects due to
under co-ordination,the production techniques
described herein can be employed, especially if
silicon is utilized as an alloying agent in combination with the narrow band gap primary materials.
The present invention also contemplates the
incorporation of the various primary materials and
compensating elements in layers as the alloy is
deposited to provide further control of alloy
properties.  In the aforementioned manner, the
instant invention overcomes the poor results
previously attributed to the fabriciation of narrow
band gap alloys in conventional vacuum systems.

Silicon is the basis of the huge crystalline
seimconductor industry and is the material which
has produced expensive high efficiency (18 percent)
crystalline solar cells.  When crystalline semiconductor technology reached a commercial state,it
became the foundation of the present huge semiconductor device maufacturing industry.  This was
due to the ability of the scientist to grow
substantially defect-free germanium and particularly
silicon crystals, and then turn them into extrinsic
materials with p-type and n-type conductivity
regions therein.  This was accomplished by diffusing
into such crystalline material parts per million of
donor (n) or acceptor (p) dopant materials introduced
as substitutional impurities into the substantially
pure crystalline materials, to increase their
electrical conductivity and to control their p or n
conduction type. The fabriciation processes for
making p-n junction crystals involve extremely complex
time consuming, and expensive procedures.  Thus, these
crystalline materials useful in solar cells and

-9-

current control devices are produced under very carefully controlled conditions by growing individual single silicon or germanium crystals, and when p-n junctions are required,by doping such single crystals with extremely small and critical amounts of dopants.

These crystal growing processes produce such relatively small crystals that solar cells require the assembly of many single crystals to encompass the desired area of only a single solar cell panel. The amount of energy necessary to make a solar cell in this process, the restrictions imposed by size limitations of the silicon crystal, and the necessity to cut up and assemble such a crystalline material have all resulted in an impossible economic barrier to the large scale use of crystalline semiconductor solar cells for energy conversion. Further, crystalline silicon has an indirect optical edge which results in poor light absorption in the material. Because of the poor light absorption, crystalline solar cells have to be at least 50 microns thick to acceptably absorb the incident sunligh. Even if the single crystal material is replaced by polycrystalline silicon with cheaper production processes, the indirect optical edge is still maintained; hence the material thickness is not reduced. The polycrystalline material also involves the addition of grain boundaries and other defect problems.

In summary, crystal silicon devices have fixed parameters which are not variable as desired, require large amounts of material, are only producible in relatively small areas and are expensive and time consuming to produce. Devices manufactured with amorphous silicon alloys can eliminate these crystal silicon disadvantages. Amorphous silicon alloys have an optical absorption edge having properties similar to a direct gap semiconductor and only a material thickness of one micron or less is necessary to absorb the same amount of sunlight as the 50 micron thick crystalline silicon. Further, amorphous silicon alloys can be made faster, easier and in larger areas than can crystals silicon.

Accordingly, a considerably effort has been made to develop processes for readily depositing amorphous semiconductor alloys or films, each of which can encompass relatively large areas, if desired, limited only by the size of the deposition equipment, and which could be readily doped to form p-type and n-type materials where p-n junction devices are to be made therefrom equivalent to those produced by their crystalline counterparts. For many years such work was substantially unproductive. Amorphous silicon or germanium (Group IV) films are normally four-fold co-ordinated and were found to have microvoids and dangling bonds and other defects which produce a high density of localized states in the energy gap thereof. The presence of a high density of localizedstates in the energy gap of amorphous silicon semiconductor films results in a low degree of photoconductivity and short carrier lifetime, making such films unsuitable for photoresponsive applications. Additionally, such films cannot be successfully doped or otherwise modified to shift the Fermi level close to the conduction of valence bands, making them unsuitable for making p-n junctions for solar cell and current control device applications.

In an attempt to minimize the aforementione problems involved with amorphous silicon and germanium, W.E. Spear and P.G. LeComber of Carnegie

-11-

Laboratory of Physics, University of Dundee, in Dundee, Scotland, did some work on "Substitutional Doping of Amorphous Silicon", as reported in a paper published in Solid State Communications, Vol 17, pp. 1193-1196, 1975, toward the end of reducing the localized states in the energy gap in amorphous silicon or germanium to make the same approximate more closely intrinsic crystalline silicon or germanium, and of substitutionally doping the amorphous materials with suitable classic dopants, as in doping crystalline materials, to make them extrinsic and of p or n conduction types.

The reduction of the localized states was accomplished by glow discharge depositon of amorphous silicon alloy films wherein a gas of silane $(SiH_4)$ was passed through a reaction tube where the gas was decomposed by an r.f. glow discharge and deposited on a substrate at a substrate temperature of about 500-600°K (27-327°C) The material so deposited on the substrate was an intrinsic amorphous material consisting of silicon and hydrogen. To produce a doped amorphous material, a gas of phosphine $(PH_3)$ for n-type conduction or a gas of diborane $(B_2H_6)$ for p-type conduction were premixed with the silane gas and passed through the glow discharge reaction tube under the same operating conditions. The gaseous concentration of the dopants used was between about $5 \times 10^{-6}$ and $10^{-2}$ parts per volume. The material so deposited including supposedly substitutional phosphorous or boron dopant and was shown to be extrinsic and of n or p conduction type.

While it was not known by these researchers, it is now known by the work of others that the hydrogen in the silane combines at an optimum temperature with many of the dangling bonds of the silicon during

-12-

the glow discharge deposition, to substantially reduce the density of the localized states in the energy gap toward the end of making the amorphous material approximate more nearly the corresponding crystalline material.

D.I. Jones, W.E. Spear, P.G. LeComber, S. Li, and R. Martins also worked on preparing a-Ge:H from GeH4 using similar deposition techniques. The material obtained gave evidence of a high density of localized states in the energy gap thereof. Although the material could be doped, the efficiency was substantially reduced from that obtainable with a-Si:H. In this work reported in philsophical Magazine B, Vol. 39, p.147 (1979) the authors conclude that because the large density of gap states the material obtained is "...a less attractive material than a-Si for doping experiments and possible applications."

After developing a successful process for the glow discharge deposition of silicon form silane gas, research was conducted to develop a process for sputter depositing amorphous silicon films in an atmosphere of argon (required by the sputtering deposition process) and molecular hydrogen, to determine the results of such molecular hydrogen on the characteristics of the deposited amorphous silicon film. This research indicated that the molecular hydrogen acted as an alternating agent which bonded in such a way as to reduce the localized defect states in the energy gap. However, the reduction of states in the energy gap achieved by the sputter deposition process was much less than that achieved by the silane deposition process described above. The p and n dopant gases (previously detailed with respect to the silane deposition process) also were introduced in the

-13-

sputtering process to produce p and n doped materials. The resultant materials possessed a lower doping efficiency than the materials produced in the glow discharge process. However, neither the vapour deposition or the sputtering deposition techniques of depositing amorphous semiconductor layers provided n-doped and p-doped materials with sufficiently high acceptor concentrations to produce commercial p-n or p-i-n junction devices. While the n-doping efficiency was below acceptable commercial levels, the p-doping efficiency was particularly unacceptable since the width of the band gap was reduced and the numebr of localized states in the band gap was increased.

Further research was conducted to additionally reduce defect states in amorphous silicon alloys or in amorphous silicon hydrogen alloys. Fluorine was found to readily diffuse into and bond to the amorphous silicon, substantially reducing the density of localized states therein, because of its reactivity occasioned by the small size of the fluorine atoms which enables them to be readily introduced into the amorphous silicon matrix. Fluorine was found to bond to the dangling bonds of the silicon in a manner which is more stable and efficient than is formed by hydrogen. However, fluorine introduced into amorphous germanium alloys or amorphous germanium: hydrogen alloys, has not up to the date of the instant invention, produced a narrow band gap material of photovoltaic quality.

Numerous attempts have been made to construct both natural and synthetic crystalline analogue materials by special layering techniques with the aim of extending the range of desirable properties which were heretofore limited by the availability of natural crystalline materials. One such attempt involved compositional

-14-

modulation by molecular beam epitaxy (MBE) deposition on single crystal substrates. For example, Dingle et al., U.S. Patent No. 4,261,771, describes the fabriciation of monolayer seimconductors by one MBE technique. These modulated prior art structures are typically called "superlattices". Superlattice fabrication techniques are based on the concept that layers of materials may be made to form a one-dimensional periodic potential by periodic variation of (1) alloy composition or (2) impurity density. Typically, the largest period in these superlattices is on the order of a few hundred Angstroms, however, monatomic layered superlattice structures have also been constructed. The superlattices can be characterized by the format of (1) several layers of a material "A" (such as GaAs), followed by (2) several layers of a material "B" (such as AlAs), in a repetitive manner. (3) formed on a single crystal substrate. The optimum superlattice is a single crystal synthetic material with good crystalline quality and long range order. Conventional superlattice concepts have been utilized for special electronic and optical effects. The most severe limitation on superlattice fabrication is they require very careful matching of lattice constants, thereby limiting the utilization of these superlattices.

In addition to superlattices, Dingle , et al., disclose quasi-superlattices and non-superlattice structures. The former are comprised of epitaxially grown crystalline islands of a foreign material in an otherwise homogeneous layered background material. The latter, non-superlattice structures,are an extension of quasi-superlattice materials in that the islands are grown into columns which extend vertically through the homogeneous layered background

-15-

material. The latter, non-superlattice structures, are an extension of quasi-superlattice materials in that the islands are grown into columns which extend vertically through the homogeneous layered backgroung material. However, these quasi and non-superlattice type structures suffer from the same defficiencies that plague homogeneous crystalline materials. There is very little variation possible in the (1) range of constitutent materials used, and (2) type of superlattices constructed, because the spacing between the layers of the lattice must approximate the spacing of the equilibrium crystalline constiutents. Futher, the superlattices are restricted to a small number of relatively low melting point crystalline materials, and the growth rates thereof are constrained by MBE techniques.

In addition to MBE superlattice construction techniques, other researchers have developed layered synthetic microstructures which utilize different forms of vapour deposition, including diode sputtering, magnetron sputtering and standard multisource evaporation.

The layer dimensions may be controlled by (1) shutters, (2) ,moving the substrates relative to the material sources, (3) control of the partial pressure of the reactive gases, or (4) combinations of shutters and substrate movement. The resultant materials have been formed form crystalline layers, noncrystalline layers and mixtures thereof. However, each of the research efforts so far reported has attempted to synthesize superlattice-type structures by precisely reproducing the deposition conditions on a periodically reoccuring basis. These materials can be thought of as synthetic crystals or crystal analogues in which the long range periodicity, the repetition of a

-16-

particular combination of layers, or the grading of layer spacing must be closely maintained. Consequently, superlattice structures, so constructed, are both structurally and chemically homegeneous in the x-y plane, but periodic in the z direction. It should be further noted that the foregoing construction approaches have only been utilized to produce materials with specific optical properties, and have not been applied to the production of materials with desirable electronic properties.

In addition to the synthetic material production techniques described above, compositionally varied materials and processes for their production are disclosed in copending U.S. Patent Application Serial No. 422,155, filed September 23,1982, entitled Compositionally Varied Materials And Method For Synthesizing The Materials, by Stanford R. Ovshinsky, which is incorporated herein by reference.

Other methods of producing alloy materials, specially adapted for photovoltaic applications, are disclosed in Applicant's U.S. Patent Nos 4,217,374; 4,226,898 and 4,342,044. The deposition techniques described therein are adapted to produce alloy materials including germanium, tin, fluorine and hydrogen as well as silicon. The alloy materials are produced by vapour and plasma activated deposition processes. Further, (1) cascade type multiple cell devices are disclosed in copending U.S. Patent Application Serial No. 427,757, entitled Multiple Cell Photoresponsive Amorphous Alloys and Devices, and (2) germanium alloys are disclosed in copending U.S. Patent Application Serial No. 427,754, entitled Method of Making Photoresponsive Amorphous Germanium Alloys and Devices.

In these prior efforts to provide alloy materials having specific properties, the resultant materials have, in some cases, been provided with desirable chemical, electrical and optical characteristics when employed in tandem or single cell photovoltaic and similar semiconductor devices. However, no narrow band gap alloy material (preferably formed of germanium, tin or lead), which has optimum chemical, electrical and optical properties for utilization as the bottom cell in a multiple cell photovoltaic device,has been fabricated. The germanium alloys which other scientists have produced and reported, possess unacceptable levels of defect states in the band gaps thereof, or other unacceptable defects. Even materials on which the assignee of the instant Application reported were not of the quality necessary to produce 30% cell efficiency. The conventional method of producing amorphous germanium and silicon alloys has been by glow discharge plasma deposition techniques. While such plasma techniques have adequately provided photovoltaic quality silicon alloys, especially with the addition of fluorine, they have not produced photovolatic quality germanium, tin or lead alloys. It is believed this is because the germanium is contaminated by the multitudinous species present in the "zoo" created as the reaction gases are disassociated and recombined by the glow discharge plasma. These numerous species often include contaminants and prevent the germanium alloy from forming the substantially tetrahedral bonding necessary to produce the highest quality material. Instead, dangling bonds, paired spin defects and other defect states result. However, a plasma technique which (1) is limited only to the excited free radicals described herein, and (2) operates in a deposition chamber at

-18-

such speeds that contaminants are not able to compete with density of states reducing elements and occupy available bonding sites, is provided as an embodiment of the instant invention.

## SUMMARY OF THE INVENTION

Disclosed herein is an amorphous, narrow band gap photoresponsive alloy and methods of producing same. The alloy consists of: a primary material selected from the group consisting essentially of (1) germanium, germanium and a dopant, tin, tin and a dopant, lead, lead and a dopant, or combinations thereof; and (2) at least one density of states reducing element for bonding with the primary material in a substantially tetrahedral manner. The narrow band gap alloy may form, as one of its principle applications, at least one layer of the lowermost cell of photovoltaic device.

The optimized narrow band gap alloy is formed in an ultrahigh vacuum environment to effectively eliminate contaminants. Further, the primary materials, and the density of states reducing element(s) are (1) activated, (2) provided in free radical form, and (3) combined on the substrate before they can recombine with one another or with other contaminant elements which may be present. The free radical species are maintained in an activated state as they are introduced into the deposition region (adjacent the substrate) to insure the formation of a desired film structure. In a contaminant free environment, atomic fluorine is especially useful to expand orbitals and promote tetrahedral co-ordination. All these factors can be combined so that the relaxation times of the excited electronic or atomic states can be optimal for the formation of the desired defect free local structure configuration. The growing film surface can be excited to further insure that a substantially tetrahedrally co-ordinated material is formed.

Simply stated, the primary materials may be forced into proper four-fold co-ordination with the atomic density of states reducing elements through chemical, electronic, physical and/or thermal excitation, if competing reactions and contaminants are eliminated. The instant invention describes methods of forcing the alloy into the proper four-fold co-ordination necessary to produce optimized narrow band gap materials.

0135294

-20-

## BRIEF DESCRIPTION OF THE DRAWINGS

Figure 1 is a diagrammatic representation of a batch vacuum deposition system for depositing the enhanced germanium or tin alloys of the present invention;

Figure 2 is a diagrammatic representation of a continuous deposition system for depositing the alloys of the present invention;

Figure 3 is a diagrammatic representation of another embodiment of a batch vacuum deposition system for depositing the alloys of the present invention; and

Figure 4 is a fragmentary sectional view of one embodiment of a multiple cascade type photovoltaic cell in which the alloys of the present invention have particular suitability.

## DESCRIPTION OF THE PREFERRED EMBODIMENT

To place the invention in proper focus, a description of the problem which has been solved will first be set forth, followed by (1) the description of the vairous embodiments of the apparatus, and (2) techniques employed to form the optimized narrow band gap alloys. It is believed previously produced narrow band gap alloys have not been optimized because of (1) defects in the band gap caused by contaminants, and (2) the tendency of the alloys to be co-ordinated in grossly non-tetrahedrally bonded configurations. The resulting alloys therefore contained both spin and spinless defects which were an effect of the distorted, non-tetrahedral bonding configurations. These may be termed "silent defects" since they are undetectable by conventional electron spin resonance (ESR) measurements.

-21-

Therefore, an alloy, measured by ESR as having a very small number of spin defects, is actually fat from an optimum photovoltaic material because of the silent defects. These defects are not as prevalent in amorphous silicon alloys (as in amorphous alloys of narrow band gap materials) since silicon has a tendency to form the necessary $sp^3$ hybrid orbitals, and become tetrahedrally co-ordinated. It should be noted that the amorphous alloys exhibiting the best efficiencies have been found to possess more perfect tetrahedral co-ordination. As described in the above referenced patents and applications in which Applicant is an inventor, fluorine is indeed a super halogen which (1) promotes and expands tetrahedral co-ordination. (2) activates and energizes the depositing species, and (3) eliminates dangling bonds. However, through the practice of the present invention, properties of these materials, in particular properties of the primary materials, can be substantially improved.

Applicant has discovered a method which yields the desired tetrahedrally co-ordinated narrow band gap alloys. The unique solution is to simultaneously promot the depositing material into a substantially tetrahedrally co-ordinated alloy while eliminating dangling bonds and spinless defects. The key is to (1) excite the depositing primary materials and defect reducing elements (2) eliminate competing contaminants, (3) provide an environment conducive to excitation of the primary materials and defect reducing elements and contaminant elimination, and (4) control the free radical lifetime and reactivity of the primary materials and defect reducing elements. By controlling (1) the free radical lifetime of the constituent materials and (2) the environment in which the materials are introduced and reacted, said alloy can be deposited in a desired tetrahedrally co-ordinated manner.

It should be noted that under extreme circumstances, fluorine can chemically react with Group IV materials to produce even higher order co-ordination, such as sixfold co-ordination by hybridization with the d orbital electrons. This does not lead to defect states. This extreme tendency for sixfold co-ordination enhances the probability that all bonds are saturated, thereby making the elimination of defects and generation of new chemical configurations more likely. As previously described, while the importance of fluorine in reducing the density of defect states and eliminating dangling bonds when forming amorphous silicon alloys cannot be overestimated, the additon of fluorine is absolutely critical when forming alloys with the lesser tetrahedrally co-ordinated elements such as germanium, tin, lead and combinations thereof. As used herein the term "substantially tetrahedrally co-ordinated" refers to a predominantly tetrahedral bonding configuration, regardless of the presence of some higher or lower order co-ordinations which normally do not produce defect states.

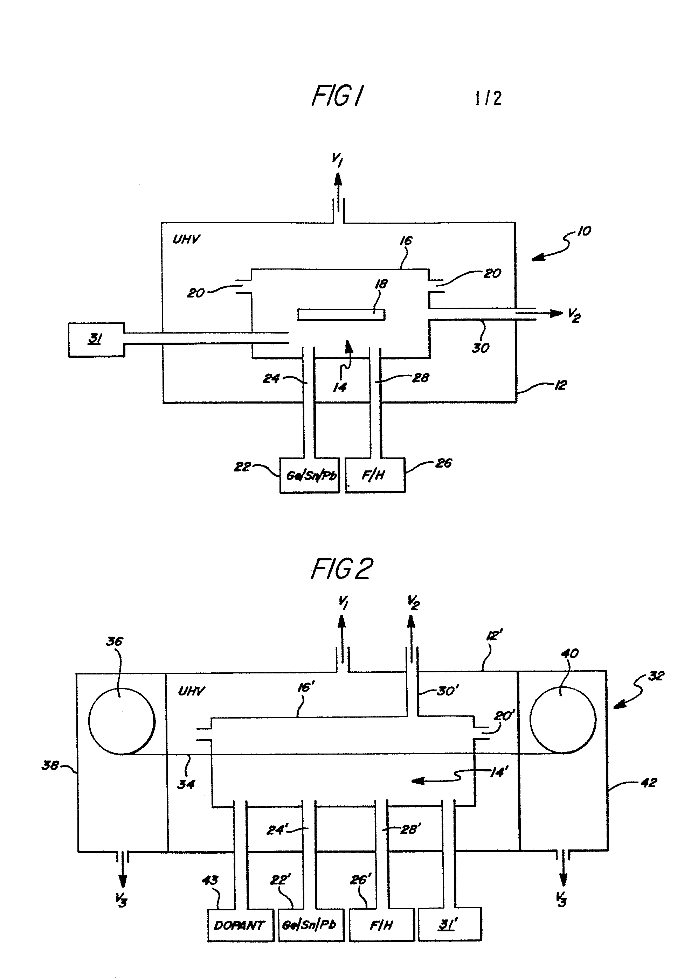

Referring now to Figure 1, a batch-type vacuum deposition system 10 is illustrated, said deposition system 10 including a UHV chamber 12 preferably maintained at a pressure $V_1$ of approximately $10^{-7}$ to $10^{-9}$ torr. A deposition region 14 is formed in a deposition chamber 16 operatively disposed within the UHV chamber 12.

The deposition chamber 16 includes a substrate 18 which can be maintained at any desired temperature by conventional heating means (not shown). The deposition chamber 16 communicates with the UHV chamber 12 through one or more chamber connecting ports 20. The deposition chamber 16 is also coupled to (1) a source 22 of germanium, tin or lead in free radical form through a primary material entry port 24, (2) a source 26 of density of states reducing material (such as fluorine and/or hydrogen), also in free radical form, through a reducing element entry port 28, and (3) a vacuum port 30 for providing a second deposition vacuum pressure $V_2$.

In operation, the deposition system 10 is preferably preheated to further eliminate contaminants. The deposition system 10 is then pumped down to the UHV range with the entry ports 24 and 28 and the vacuum port 30 closed so both chambers 12 and 16 are vacuumized to the UHV pressure $V_1$. The vacuum port 30 is then opened to bring the pressure of the deposition region 14 of the deposition chamber 16 to the deposition pressure $V_2$ (which is generally higher than the UHV pressure $V_1$ ). The entry ports 24 and 28 are then opened to introduce the proper activated (1) primary materials such as Ge, doped Ge, Sn, doped Sn. Pb. doped Pb or mixutes thereof, and (2) the density of states reducing elements fluorine, or hydrogen or mixtures thereof, into the deposition chamber 16. The entry ports 24 and 28 are operatively coupled to the interior of chamber 16 so as to introduce the activated species into the deposition region 14 at such a distance from the substrate 18 that the free radical lifetimes of the primary materials and reducing elements are not quenched before deposition onto the surface of the substrate in an activated form. The desired tetrahedral coordination of the alloy material is thereby provided.

The sources 22 and 26 provide the constituent materials in free radical form, without contaminants, said species adapted to combine on the surface of the

-24-

substrate 18 as a tetrahedrally co-ordinated alloy.

Again, fluorine is the most efficient promoter of tetrahedral co-ordiantion in the absence of contaminants which can compete for available bonding sites. The excited constituent materials are introduced into the deposition region 14 at such a distance from the substrate 18 that, rather than recombining in the region 14, they combine on the surface of the substrate 18 before relaxation can occur. Atomic hydrogen, taken alone, or in combination with fluorine, also can be utilized to combine with ther germanium, lead, or tin and form the tetrahedrally co-ordinated alloys by eliminating some of the defect sites. It also is possible to provide a separate source of hydrogen for introduction into the deposition chamber 16, whether used alone or in conjunction with fluorine. As with fluorine, atomic hydrogen (1) is also more effective than molecular hydrogen in reducing defects in the absence of competing contaminants, and (2) can help promote tetrahedral co-ordination, especially with the depositing constituent materials are excited to free radical form.

Excitation of the depositing species can be provided by a source of excitation 31 which is directed into the deposition region 14 of the deposition chamber 16. In this manner the energy needed to promote tetrahedral co-ordination is provided. The source 31 can be a laser, microwave generator, radio frequency generator, electron beam gun, X-ray beam generator, photoexitor such as ultraviolet light, or an ultrasonic source. Regardless of the source of excitation 31. It can be tuned to excite the desired deposition constitutent materials, such as germanium, tin, lead fluorine, hydrogen or combinations thereof, and can take the form of a plurality (not shown) of like sources tuned to excite the individual species. The excited species in the UHV system, not having to compete with contaminants, form new configurations in both the gaseous and alloy phase. Whereas, small amounts of impurities are acceptable in amorphous wider band gap semiconductor materials, even trace amounts of impurities are totally unacceptable and destructive in amorphous narrow band gap semiconductor materials.

As an example of the critical importance of the UHV environment, note the fact that a tetrahedral material will readily incorporate oxygen. If oxygen is incorporated to form totally divalent bonds, the defects need not be seriously detrimental. However, if oxygen is incorporated in a non-bridging manner, then it can introduce localized defect states in the band gap, thereby deleteriously effecting the properties of the alloy material. Due to its threefold co-ordination, nitrogen is even more likely than oxygen to introduce defects in the alloy material into which it is incorporated. Carbon has multi-bonding possibilities and is therefore capable of introducing defects, especially as its percentage in the alloy is increased. Water moisture is harmful because resulting OH radicals provide weak hydrogen bonding which can lead to metastable defect states. Therefore, reducing the impurity noise level which contaminating materials such as oxygen, nitrogen, carbon and water cause, enables (1) hydrogen and fluorine to eliminate dangling bonds, and (2) fluorine to incorporate the unused, but necessary alloy orbitals. Due to its reactivity, atomic hydrogen, vis-a-vis molecular hydrogen, can effect some of the ordinarily non-reactive alloy orbitals, even though it does not have the expansion capabilities of fluorine. The invention provides for the activation or energization of elements necessary to form the low band gap alloy, thereby resulting in tetrahedral bonding configurations in hybrid $sp^3$ orbitals.

Referring to Figure 2, a second embodiment of a deposition system is illustrated. The continuous deposition system depicted therein, generally 32, includes essentially the same vacuum chamber 12', deposition chamber 16' as depicted in the Figure embodiment, sources of reaction materials 22' and 26', entry ports 24' and 28' and vacuum port 30' and a deposition region 14'. In contrast to the batch deposition system 10, the continuous system 32, includes a substantially continous substrate web 34 which is fed from a payout roll 36 in an operatively interconnected chamber 38 into the vacuum chamber 12' and then into the deposition chamber 16' where the alloy is deposited thereonto. Following the deposition of the alloy which deposition can be continuous of intermittent, the web 34 is fed onto a take up roll 40 in an operatively interconnected takeup chamber 42. The chambers 38 and 42 are maintained at a pressure $V_3$ which is preferably higher than either of pressures $V_1$ in the vacuum chamber 12' or $V_2$ in the deposition chamber 16'. The chamber 12' can include a plurality of chambers 16' operatively interconnected for the deposition of successive layers of alloys. Such interconnected chambers can be utilized to form a multiple layer p-i-n type semiconductor device.

In order to provide doped layers, one or more dopant sources 43 are operatively coupled so as to introduce dopant materials into the deposition region 14'. Preferably, a separate source 43 is provided to introduce each dopant material into an individual deposition chamber 16' (except for those instances in which a plurality of dopant materials are to be deposited in the same layer). For example, boron is conventionally utilized as a p type dopant material and phosphorous is a conventional n type dopant material. While small amounts of boron thus serve a useful purpose, large amounts can cause defects and are thus considered contaminants. To eliminate the possibility of having boron cause additional defects, a second p type dopant material can be utilized such as aluminum. Further, to insure that the dopants are properly introduced into the depositing alloy, they are preferably excited by one or more sources of excitation 31' (only one of which is shown). Each of the sources of alloying material contains ultrapure material which further serves to eliminate contaminants, such as oxygen, nitrogen, carbon and water vapour from the system.

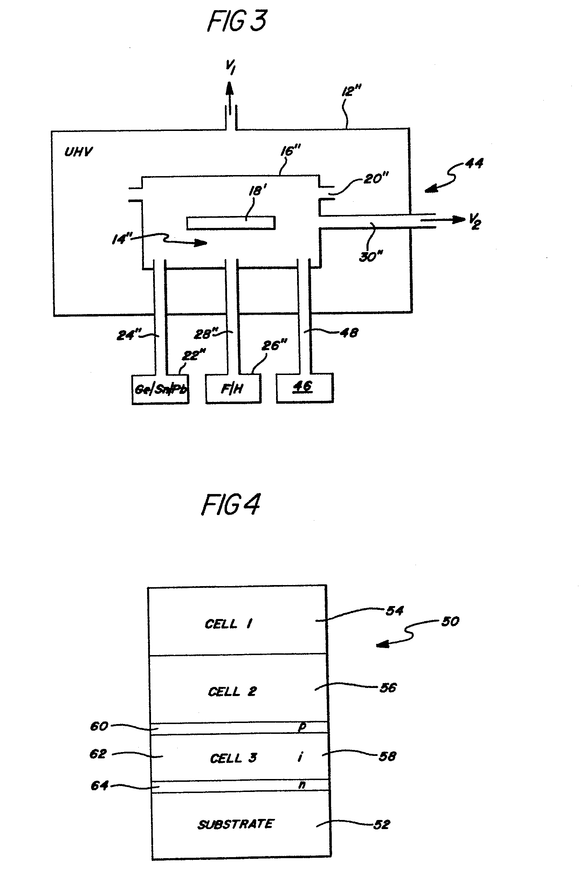

In a third embodiment, a batch deposition system 44 is illustrated in Figure 3. This system is essentially identical to the batch deposition system 10 of Figure 1 with the additon of at least one substrate excitation source 46 which is coupled to the depositon chamber 16" through a port 48. As explained with respect of excitation source 31' the excitation source 46 further insures the alloy is tetrahedrally bonded by properly exciting primary materials and the defect reducing elements as they are deposited onto the surface of the substrate 18'. The alloy being grown on the surface of the substra . 18' is excited to avoid nucleation or columnar growth, which is prevalent (especially in germanium alloys).

The germanium, tin or lead alloy material is most preferably utilized in the multiple cascade type photovoltaic cell 50 illustrated in Figure 4. The cascade cell 50 includes a substrate 52 upon which at least two, but preferably three cells 54, 56 and 58 are deposited. The top cell 54 is generally formed of an alloy material, such as an amorphous silicon alloy, having a band gap of 1.7 to 1.9 eV, as described by U.S. Patent Serial Nos. 4,217,374 and 4,226,898. The second cell 56 is generally formed of an alloy material, such as an amorphous silicon-germanium alloy, having a band gap of 1.4 to 1.7 eV, as described by U.S. Patent Serial No. 4,342,044. The third cell 58 is formed of one of the alloys of the instant invention having a band gap of .8 to 1.3 eV (preferably about 1.1 eV) as described herein.

Each of the cells 54, 56 and 58 preferably have a p-i-n configuration and are matched so the currents generated in each cell are substantially equal. In this manner, light is directed serially through each of the cells in succession with the result that the voltage generated by the device is equal to the sum of the voltage generated by each individual cell. The cell 58 is shown formed by a p doped layer 60, an intrinsic layer 62 and an n doped layer 64, however n-i-p cells also can be utilized. The alloy of the instant invention is employed at least in the intrinsic layer 62 of the lowermost cell 58 for provinding a narrow band gap lower cell which is matched to the current generating capabilities of the upper successively wider band gap cells. The doped layers 60 and 64 can alternatively be formed from the alloys of this invention or can also include the conventional silicon alloys. Further, one or more band gap adjusting elements, such as carbon or nitrogen, can be utilized to increase the band gap of the cells as desired. In addition to its aforementioned properties, fluorine permits the use of carbon and nitrogen to increase the band gap, if

-29-

the adjusting elements are carefully incorporated as alloying elements rather than as impurity elements, such as by the excitation techniques described above.

Since tetrahedral co-ordination is insured by the methods and apparatus described herein, numerous possible alloy materials can be utilized for changing or adjusting the band gap without increasing the density of states. The alloy materials include combinations, whether doped or undoped, of germanium and/or tin and/or lead as well as silicon. The addition of silicon as an element of the alloy material is enhanced by this method, since conventionally prepared thin film germanium-silicon alloys have too many defect states in the band gap for fabricating an optimum tandem photovoltaic device. The cascade cell 50 formed according to the principles of the instant invention is capable of providing photovoltaic devices having efficiencies greater than 30%.

It should finally be noted that according to principles embodied herein, other elements which enhance tetrahedral co-ordination over divalent co-ordination may be added to the primary material and/or density of states reducing element in trace amounts. These elements defined herein (without limiting their other possible beneficial properties) as "tetrahedral co-ordination enhancers", not only can increase tetrahedral structure, but can (1) act as chemical compensators and (2) fill spaces to force tetrahedralness. This is accomplished due to (1) the size of the atoms introduced into the host matrix, (2) the charge of the atoms introduced into the host matrix, and (3) filling all four bonding positions (for example, a divalent atom attaching itself to the divalency of germanium).

-30-

Modifications and variations of the present invention are possible in light of the instant disclosure. For instance, (1) one or more of the element sources can be ion guns, such as differential ion guns, or (2) the elements can be provided by evaporation techniques. While not every embodiment has been depicted in each figure, so as to avoid unduly complicating the drawings, each source can be separately provided in each of the illustrated deposition systems. The deposition regions, 14, 14' or 14" may be further isolated by magnetic confinement. Also, the elements may be introduced into the alloys in any percentage desired in accordance with the techniques described in U.S. Patent No. 4,342,044. By the term "amorphous" is meant an alloy or material which has long range disorder, although it may have short or intermediate order or even contain at times some crystalline inclusions. It is therefore, to be understood that within the scope of the appended claims the invention may be practiced otherwise than as specifically described.

What is claimed and desired to be secured by Letters Patent of the United States is:

CLAIMS:

Claim 1.    An improved narrow band gap amorphous alloy
for photovoltaic applications comprising:

    an alloy consisting of: (1) a primary material
selected from the group consisting essentially of
germanium, germanium and a dopant, tin, tin and a dopant,
lead, lead and a dopant, or combinations thereof:
and (2) at least one density of states reducing
element for bonding with the primary material and
substantially preventing contaminants from occupying
available bonding sites; said alloy being substantially
tetrahedrally co-ordinated with hybrid orbitals.

Claim 2.    The alloy as defined in Claim 1, wherein
said alloy is substantially tetrahedrally co-ordinated
with $sp^3$ hybrid orbitals.

Claim 3.    The alloy as defined in Claim 1 wherein:
said at least one density of states reducing element
is atomic fluorine for promoting and expanding the
lone pair orbitals of the primary material to result
in said tetrahedral co-ordination.

Claim 4.    The alloy as defined in Claim 1 wherein:
said alloy also includes silicon.

Claim 5.    The alloy as defined in Claim 1 wherein:
said alloy includes a tetrahedral co-ordination enhancer.

Claim 6.    A method of making an enhanced narrow band
gap amorphous semiconductor alloy for photovoltaic
applications, said method comprising:

    providing an environment conducive to the formation
of tetrahedral co-ordination;

    exciting a primary material selected from the group
consisting essentially of germanium, germanium and a
dopant, tin, tin and a dopant, lead, lead and a dopant,
or combinations thereof with energy to have a first
excited energy lifetime;

Substantially excluding from said environment contaminants which can compete for bonding sites with the density of states reducing element, quench excitation energy and quench free radical lifetime;

forming a localized deposition region within said conducive environment;

providing a substrate in said deposition region;

introducing said excited primary and said density of state free radicals into said deposition region within a distance from the substrate related to the respective lifetime to exclude bonding interference from any contaminants remaining in the environment, so that said at least one density of states reducing element and said primary material are deposited on said substrate to form a substantially tetrahedrally co-ordinated alloy with hybrid orbitals.

Claim 7. The method as defined in Claim 6, wherein the step of providing a conducive environment includes the further step of: forming an ultrahigh vacuum environment.

Claim 8. The method as defined in Claim 7 wherein the step generating free radicals of a density of states reducing element includes the further step of: generating free radicals of fluorine to promote and expand said tetrahedral co-ordination.

Claim 9. The method as defined in Claim 7 including the further step of: incorporating silicon in said alloy.

Claim 10. The method as defined in Claim 7 including the further step of: incorporating a tetrahedral co-ordination enhancer in said alloy.

Claim 11.  An improved multiple cell photovoltaic device comprising:

at least two serially deposited photovoltaic cells, the cells formed such that photocurrents generated by each cell, as light passes therethrough, are substantially matched to one another; and

the lowermost of said at least two cells formed a narrow band gap amorphous alloy, said alloy consisting of: (1) a primary material selected from the group consisting essentially of germanium, germanium and a dopant, tin, tin and a dopant, lead, lead and a dopant, or combinations thereof, and (2) at least one density of states reducing element for (a) bonding with the primary material, (b) substantially preventing all contaminants from occupying bonding sites, and (c) being substantially tetrahedrally co-ordinated with hybrid orbitals.

Claim 12.  The device as defined in Claim 11 herein: said alloy incorporates silicon.

Claim 13.  The device as defined in Claim 11 wherein: said alloy includes a tetrahedral co-ordination enhancer.

0135294

FIG 1    1/2

FIG 2

2/2

## FIG 3

UHV

$V_1$

12''

16''

18'

20''

44

14''

$V_2$

30''

24''    28''    26''    48

22''

Ge/Sn/Pb    F/H    46

## FIG 4

CELL 1    54    50

CELL 2    56

60    p

62    CELL 3    i    58

64    n

SUBSTRATE    52